(19) Europäisches Patentamt
European Patent Office
Office européen des brevets

(11) Publication number: **0 045 600**
**B1**

(12) # EUROPEAN PATENT SPECIFICATION

(45) Date of publication of patent specification: **10.10.84**

(51) Int. Cl.[3]: **C 30 B 25/18,** C 30 B 29/06, C 01 B 33/02, C 30 B 25/14

(21) Application number: **81303402.2**

(22) Date of filing: **24.07.81**

(54) **Improved method for producing semiconductor grade silicon.**

(30) Priority: **28.07.80 US 172623**
**28.07.80 US 172625**

(43) Date of publication of application:
**10.02.82 Bulletin 82/06**

(45) Publication of the grant of the patent:
**10.10.84 Bulletin 84/41**

(84) Designated Contracting States:
**BE CH DE FR GB IT LI NL**

(56) References cited:
**DE-A-2 558 387**
**DE-B-1 216 842**
**FR-A-2 185 445**
**GB-A-1 112 140**
**US-A-3 012 862**

***SOLID STATE TECHNOLOGY*, *vol. 13, no. 4*, April 1970 A.C. IPRI et al. "Epitaxially deposited Si from a SiH4 HCl mixture", page 38**

(73) Proprietor: **MONSANTO COMPANY**
**Patent Department 800 North Lindbergh Boulevard**
**St. Louis, Missouri 63166 (US)**

(72) Inventor: **Gutsche, Henry William**
**1659 Pepperwood Drive**
**St. Louis Missouri 63141 (US)**

(74) Representative: **Lunt, John Cooper et al**
**Monsanto Europe S.A. Patent Department**
**Avenue de Tervuren 270-272 Letter Box No 1**
**B-1150 Brussels (BE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the Invention

This invention relates to an improved process for growing silicon bodies resulting from chemical vapor deposition upon silicon carrier bodies. Another aspect of the invention relates to a process for improving the deposition rate of silicon upon silicon carrier bodies resulting from the addition of controlled amounts of silane to the silicon halide-hydrogen reaction gases which are then brought into contact with the hot silicon carrier bodies. In yet another aspect, the invention relates to a process for increasing the silicon deposition rate from silicon halide-hydrogen reaction gases within any chemical vapor deposition environment having the purpose of increasing the efficiency and deposition rate of silicon.

In the semiconductor industry, it is common to deposit material from the gaseous state onto a substrate for the purpose of forming various electronic devices. In some applications the material deposition of the gas is the same material as that from which the substrate is formed, while in other instances it is a different material from that from which the substrate is formed. As an example of the former, in the growth of silicon by vapor deposition techniques, it is common to position an elongated silicon filament between two graphite electrodes each of which extend through the end of a quartz container within which the filament is placed. A potential is impressed across the graphite electrodes causing a current to flow through the filament. The resistance of the filament produces a temperature generally in excess of about 1100°C.

A gas stream, which comprises a mixture of trichlorosilane and hydrogen is introduced into the quartz chamber and after flowing along the longitudinal axis of the filament is withdrawn from the chamber. The gas stream, upon contacting the hot surface silicon filament, will react to deposit polycrystalline silicon on the filament, thus increasing the diameter of the filament. The reaction of the trichlorosilane and hydrogen may be generally illustrated by the following simplified formula:

$$SiHCl_3 + H_2 \rightarrow Si + 3HCl.$$

Gas flow through the quartz cylinder or reaction chamber is usually continued for several hours to increase the diameter of the filament, which may be one-tenth inch in diameter upon commencement of the deposition, to the diameter in excess of five inches. When the silicon rod has reached a desired diameter, the flow is terminated and the rod is removed from the reaction chamber. Material deposited on the silicon filament will be polycrystalline and therefore must be zone melted to produce a single crystalline material. Alternatively, the polycrystal rod may be melted in a crucible and a large single rod is "pulled" from the melt by way of a variety of apparatus such as a Czochralski puller.

In both commercially accepted methods of producing single crystal silicon for the electronics industry, that is by float zone or by Czochralski, the single crystal rod which is drawn from a melt in both cases is rotated and results from the pulling of the melt in the form of the single crystal rod. Such methods require considerable skilled technician monitoring as well as multiple furnaces requiring substantial energy for operation. Even under the best conditions, frequently the crystal is lost during the first stage which means that the rod being pulled converts to a polysilicon growth zone; thus terminating the growth procedure of the rod. Such commercial methods of producing remelt single crystal silicon rod materials are costly in time and effort and frequently produce irregularly shaped cylindrical rods requiring substantial premachining before slicing and conversion into wafers for use in the electronics industry.

In addition to the above commercial production means for producing polycrystalline silicon, elemental silicon of electronic purity can be obtained by contacting a bed of silicon seed particles or carrier bodies at elevated temperatures with a hydrogen-stream containing a reduceable silicon compound such as silicon halide or a halosilane. Such process involves the charging of silicon seed particles through a suitable reactor wherein the seed particles are fluidized and maintained at temperatures ranging from about 1000°C to about 1250°C. Hydrogen and trichlorosilane, for example, are passed through the bed at a rate sufficient to fluidize the seed particle bed while depositing additional elemental silicon thereon by hydrogen reduction of the trichlorosilane or other reducible silicon compound. One advantage of such a process has been the feature of continuously or semi-continuously removing large silicon particles therefrom as a product of the process while concurrently adding seed particles to replenish the fluidized bed.

A further method for producing elemental silicon of electronic purity is found in fluid wall reactor processes wherein the reaction gases are not allowed to come in contact with the reactor walls. Such a process permits shifts to be made in the thermodynamics and kinetics of the silicon halide-hydrogen reaction process which heretofore was unattainable because of wall coating problems. Such processes are described in our copending European Patent Applications EP—A—0045599 and EP—A—0045192.

Whether using the older slim rod process or the more recent fluidized bed or fluid wall reactor, the technical and economical feasibility of producing high-purity polycrystalline silicon of semiconductor quality by hydrogen reduction of silicon halides has been demonstrated. All commercial semiconductor polycrystalline silicon presently being manufactured through chemical vapor deposition processes employ hydrogen reduction of trichlorosilane or silicon tetrachloride and the deposition of silicon on heated silicon carrier bodies.

Epitaxially-grown single crystal silicon by chemical vapor deposition (CVD) has been known since the early 1960's. It is also known to utilize the volatile acceptor or donor impurity precursors during growth process of silicon; thus leading to the formation of electrically-active regions, bounded by junctions of varying thicknesses, carrier concentrations, and junction profiles. Vapor substrate growth systems are quite general and in principle applicable to systems which are providing pertinent kinetic and thermodynamic conditions of satisfactory balance.

- The growth of single crystal silicon, for example, from the vapor phase is dependent on several important parameters all of which interreact with each other to some degree. These parameters can be described in part, for example, as substrate surface crystalographic orientation, the chemical system, reaction variables, such as concentration, pressure, temperature modification, and the appropriate kinetic and thermodynamic factors. A variety of reaction systems have been investigated; however all have the common feature that a hot single crystal surface or a polycrystalline surface is exposed to an atmosphere which is thermally and/or chemically decomposable. The mechanism of the silicon-forming reaction is a function of the temperature of the substrate.

In the growth of polycrystalline silicon or single crystal silicon from deposition of silicon resulting from silicon halide-hydrogen reaction gases, the purity of the reaction gas is critical and is obtained by careful fractional distillation and by the particular design of the apparatus which assures that all materials used in the apparatus construction are very pure and do not promote contamination of the silicon halide-hydrogen reaction gases or depositing silicon under conditions of deposition. These requirements restrict the practical choice of materials that can be used for the construction of apparatus for the preparation of semiconductor silicon to quartz, graphite, silicon carbide, silver, and the like. Silver must always be thoroughly water cooled in order to avoid chemical reaction. The silicon halides used most for the preparation of high purity silicon are silicon tetrachloride and trichlorosilane. These halides will undergo pyrolysis when in contact with the hot surface and deposit elemental silicon. To obtain reasonable and economical yields, however, an excess of hydrogen gas is added to the silicon halides vapor reaction feed gas. Because of its higher silicon content, trichlorosilane will deposit more silicon than silicon tetrachloride and is therefore the preferred material for the Siemens' process for the preparation of polycrystalline silicon. However, silicon tetrachloride is preferred for the preparation of thin epitaxial films of single crystal silicon.

Silicon halides with less than three chlorine atoms in the molecule like $SiH_2Cl_2$ and $SiH_3Cl$ in particular, deposit much more silicon per mole of silicon halide consumed in the reaction but are impractical because they are not readily available and thus less desirable economically.

When trichlorosilane ($SiHCl_3$) or silicon tetrachloride ($SiCl_4$) are used in the seed rod process, the overall reactions are assumed to be

1. $SiHCl_3 + H_2 \rightarrow Si + 3HCl$ and
2. $SiCl_4 + 2HCl \rightarrow Si + 4HCl$.

For a silicon halide to hydrogen mole ratio of 0.05%, thermal dynamic equilibrium is reached at 1150°C when approximately 48% of the $SiCl_3$ moles have reacted, Or 24% of the $SiCl_4$ moles. In practice, however, equilibrium is not reached in a flow-through system because the kinetics of the reaction limit the actual steady state silicon yields to about one-half of the equilibrium values, the hydrogen chloride desorption from the substrate surface being the rate controlling step in both reactions.

Any occurrence on the substrate surface that could accelerate the hydrogen chloride desorption movement of hydrogen chloride away from the surface would accelerate the deposition rate of silicon and improve the economics of the process. One proven way to accomplish this result is to improve the deposition rate by accelerating the desorption rate of hydrogen chloride by raising the temperature of the substrate surface. This approach is effective but only when relatively small concentrations of silicon halide in the reaction gas are employed. These low mole ratios are lean mixtures and result in high yield but low weight gains. Rich mixtures do not respond in the desired manner because of side reactions as follows: $SiHCl_3 \rightarrow (SiCl_2) + HCl$ and $SiCl_4 + Si \rightarrow 2(SiCl_2)$; the side reaction producing the radical ($SiCl_2$) which is stable at the reaction temperature range and reduces the amount of reactive silicon halide available for absorption and reaction on the substrate surface. As a net effect, we see, in spite of the faster HCl desorption, less silicon being deposited as we increase the substrate surface temperature from, for example, 1150°C to 1250°C when molar ratios in excess of 0.05 in the trichlorosilane system and in excess of 0.01 molar ratio in the silicon tetrachloride system are utilized. In fact, at molar ratios of about 0.1 in the silicon tetrachloride system, the formation of ($SiCl_2$) becomes the dominant reaction and silicon is removed from the substrate at about 1200°C.

Another approach to improved deposition rates would be to use mixtures of silicon halides so that the overall silicon chlorine ratios increase. For example, silane ($SiH_4$) offers itself as an effective diluent and having no chlorine in the molecule would improve the silicon to

chlorine ratios of silicon halide reaction gas mixtures. Silane as such cannot be used readily as a starting reaction material for the Siemens' process. Silane is not stable and decomposes spontaneously at 400°C forming silicon and hydrogen. The silicon, unfortunately, forms a dust which is not suitable for further processing rather than a controlled deposition upon a seed rod. Only in greatly diluted reaction gas stream wherein hydrogen, helium, or the like is utilized in the presence of hydrogen chloride, can silane be used to prepare silicon in crystalline form. Particular application is therefore limited mostly to slow deposition rate processes which are used exclusively in the thin film preparation field.

Summary of the Invention

To overcome the difficulties cited above, the improved process according to the invention, which is defined in the appended claims, provides enhanced efficiency and deposition rate in preparing electronic grade silicon bodies from the deposition of silicon upon hot silicon carrier bodies. The method according to the invention provides high-purity elemental silicon primarily for electronic semiconductor applications and in that respect is a significant improvement on the prior art methods. While for the purposes of this invention description, the process is described as relates to an improved silicon deposition process utilizing chemical vapor deposition technologies, the inventive process would enhance all silicon halide-hydrogen deposition systems.

The invention is predicated on the use of old and new apparatus refinements, thermodynamics and reaction kinetics wherein carrier bodies of crystalline silicon are exposed to silicon halide-hydrogen reaction gas mixtures at decomposition temperatures with the improvement being that the reaction gas is comprised of from 0.2% to 5% by weight silane in addition to the silicon halide-hydrogen feed stream. The introduction of small percentages by weight of silane to the silicon halide-hydrogen reaction gas, for example trichlorosilane and/or silicon tetrachloride produces increases in deposition rate which are beyond that attributable to the stoichiometric amounts of silane added to the reaction gas feed stream. A significant deposition rate enhancement occurs through the utilization of silane; thus the improvement according to the invention is suitable for any electronic-grade silicon production wherein silicon halide-hydrogen reaction gases are thermally decomposed providing silicon for deposition growth upon hot silicon carrier bodies.

The use of a reaction gas containing a small percentage of silane in accordance with the invention is particularly advantageous in a continuous process for preparing bodies of crystalline silicon comprising heating one or more silicon slim rods to decomposition temperatures of silicon halide-hydrogen reaction gas mixtures, passing the heated silicon slim rods into a chemical vapor deposition chamber; maintaining surface temperature of the silicon slim rods from about 1000°C to about 1300°C through heating means; contacting the silicon slim rods with the reaction gas comprised of silicon halide-hydrogen, said reaction gas containing from 0.2% to 5% by weight of silane; depositing silicon on the slim rods as the rods are moved through the decomposition chamber; and withdrawing the resulting enlarged crystalline body from the decomposition chamber.

The silicon slim rod which is passed into the chemical vapor deposition chamber in accordance with the above embodiment of the invention can be produced in situ and continuously drawn into and through the chemical vapor deposition chamber while being heated before entry into the chamber and simultaneously exposed to further heating and silicon halide-hydrogen reaction gases as described in EP—A—0045191.

In addition, use of an interior cooled wall through gas curtain means which also prohibits reaction gas from making contact with inner chamber walls may be utilized in combination with the inventive selected reaction gas feed mixture. For example, rather than use of an external gas such as air to regulate the chamber wall temperature, it is proposed to use one or more gas curtains to cool the inner wall directly; thus creating fluid or gas curtains along the substantial length of the inner wall.

A high velocity helium or hydrogen gas flow along the inner wall of the chamber from the bottom portion or in the alternative countercurrent to the reactor gas flow provides an effective gas curtain which prevents reaction gas from reaching the inner chamber wall surface; thus avoiding silicon deposits on the inner chamber wall for a substantial portion of the chamber. However, the effectiveness of such a curtain has certain limitations, and improvements are obtained by using a second gas curtain to be introduced at the upper end of the chamber wall or parallel to the reaction gas flow inlet as described in EP—A—0045599. The upper chamber gas curtain is comprised of HCl for cooling purposes as well as providing the gas curtain barrier between the upper chamber inner wall portion and the reaction gas. In addition the HCl curtain can be manipulated under process conditions to provide inner chamber wall etching if such etching is found to be necessary. Proper manipulation of for example, the HCl and hydrogen curtain prevents silicon deposition on the walls while also providing additional dilution of the silicon compound gases and in some cases preheating of process gases when the curtain gases are recycled in combination with reaction gas feed streams.

By providing the quartz CVD chamber with certain gas inlets both at the top and at the bottom, the process allows for substantial hydrogen curtain to flow, for example, from the bottom of the chamber along the chamber walls providing effective cooling where it is needed most and a lesser volume HCl curtain entering the chamber tube from the upper portion wherein the hydrogen curtain effectiveness is limited. With this arrangement, the upper chamber walls can be protected from wall coatings which otherwise usually occur in a silicon-hydrogen-halogen system surrounding a 1200°C substrate.

The invention provides a process for increasing silicon deposition rate from silicon halide-hydrogen gas systems which are capable of pyrolytically depositing silicon on heated silicon carrier bodies under conditions which promote polycrystalline and in some cases single crystal silicon deposition. The process increases the silicon deposition rate from silicon halide-hydrogen reaction gases wherein electronic-grade silicon bodies can be produced utilizing the step of introducing small percentages by weight of silane to the silicon halide-hydrogen reaction gases, for example, trichlorosilane and/or silicon tetrachloride. A significant deposition rate enhancement occurs through the utilization of controlled amounts of silane in combination with the silicon halide-hydrogen reaction gas feed. The thermodynamics of silicon halide-hydrogen systems are generally understood and the equilibrium compositions are fully quantified; however the kinetics of silicon vapor deposition (CVD) are not completely understood and multiple reactions appear to occur. Quantitatively it is known that the deposition rate of silicon rises rapidly with temperature, then is less sensitive to temperature at higher temperatures, and may even drop with further increases in temperature within the upper limits. Mass transfer and heat transfer in silicon CVD systems utilizing radiant heating have not previously been well understood and mostly continue to be evasive of exact quantification. Due to the complexity of the CVD process two specific goals were necessarily resolved through the invention, the enhanced direct silicon deposition rates while avoiding wall deposition or silicon dust.

The improved method according to the invention can be utilized in a variety of chemical pyrolytic decomposition systems wherein silicon is decomposed and deposits upon hot carrier bodies. However, behind this simple description, a number of complex phenomena remain for the most part unresolved. Chemical thermodynamics establish the maximum obtainable yields which depend on temperature and initial mole ratios. Various phase and gas/solid reactions are involved, the kinetics of which depend on temperature, gas composition, and crystal orientation. Absorption-desorption of reaction end product on crystal surfaces is also temperature dependent as are the rates in crystal growth nucleation. Finally, the gas composition and temperature on the crystal surface are affected by the flow pattern in the reactor which determines mass transportation transfer.

Before discussing the apparatus illustrated which represents only one of several methodologies suitable for the improvements offered by the present invention, it is noted that the main feature of the invention is to allow one to select specific deposition rates at optimum value and to maintain this value during the entire deposition process. In that regard, it is desirable to select a deposition rate as large as possible, but in so doing to also insure that neither homogeneous nucleation of silicon in the feed gas phase nor deposition of silicon on the interior walls of the reactor walls occurs. In addition, the utilization of properly-prepared silicon carrier bodies creates the best possible deposition surface for creating single crystal or polycrystal silicon bodies.

Figure 1 of the accompanying drawings is a schematic and partially in-section presentation of an apparatus which can be utilized in performing the method of the invention;

Figure 2 shows an apparatus wherein a combination of two gas curtains is provided along the walls of the chemical vapor deposition chamber and which can be utilized in the practice of the continuous embodiment of the method of the invention.

In Figure 2, hydrogen, to act as a reducing carrier gas, is taken from hydrogen tank 1 through shut-off valve 2 in a plural stage pressure reducing valve 3 and passes through a gas quantity meter 4 into a gas evaporator 5 where the hydrogen is mixed with the evaporation reaction gas (source not shown) such as silicon tetrachloride or trichlorosilane and silane. The silane is stored in tank 6 and flows through shut-off valve 7, pressure-reducing valve 8 and through gas quantity meter 9. The mixture is passed through a gas supply pipe 10 and through a nozzle 11 into the processing space, the nozzle 11 producing a turbulent flow. The gas mixture passes along to carrier rods 13 of silicon which are electrically connected in series and during processing are transversed by alternating current supplied from an alternating current line in the terminals 12 for the purpose of heating the rods from about 1000°C to about 1300°C, preferably from about 1100°C to about 1250°C. The carrier rods 13 are firmly attached to coaxial holders 15 of graphite and are sealed from the ambient atmosphere by means of a quartz cylinder 14. The upper end of the rods 13 are interconnected by bridge 16 of silicon which forms a current-conducting connection between the rods. The spent residual gases leave the processing space through a heat insulated outlet pipe 17 and flow along the gas inlet pipe in the direction opposed to that of the incoming gas mixture.

In Figure 2 of the drawings, a source feed rod of polycrystalline silicon 18 having a direct current connection 51 is automatically fed through means 93 in through seal means 97 into the

virgin seed rod pulling chamber 91. The direct current connection 51 is utilized for resistive preheating of the virgin seed rod or slim rod 19 before entry into the chemical vapor deposition chamber 23. The source rod seal means 97 can be of various constructions which allow longitudinal transport into a pressurized chamber. The slim rod pulling chamber 91 is equipped with chamber inlet gas facilities 41 which maintains a positive pressure upon the pulling chamber 91 utilizing, for example, hydrogen or helium or some other suitable gas which is inert to the thermal decomposition reactions which occur in the CVD chamber 23. Pulling chamber 91 may be vented by outlet means; however, the positive pressure should be maintained and the outlet can be through the quartz sleeve 21.

The source feed rod 18 provides a source rod melt 47 through utilization of a high energy heating coil 45, for example, similar to physical conditions utilized in commercial float zone technology. The virgin slim rod 19 is produced through the action of a single crystal seed and drawing of same from the source rod melt 47. The virgin slim rod 19 is continuously pulled from the pulling chamber 91 into and through the CVD chamber 23 through a communication zone between chambers 91 and 23 comprised of a quartz sleeve 21 which serves the purpose of reducing temperature loss of the CVD chamber and in combination with the positive pressure of the pulling chamber 91 prohibits process or reaction gas loss from CVD chamber 23. In addition, the quartz sleeve 21 in the restrictive communication zone between the two chambers prohibits contact of the seed rod 19 with the process gas in the CVD chamber 23 until ideal reaction conditions exist which occur upon entry into the CVD chamber 23 through the simultaneous focused heating from the radiant heat furnace 25 in combination with CVD chamber 23 transparent walls 27. The slim rod 19 is contacted with process gas from the process gas feed head 26 which is in communication with process gas inlet 28. Hydrogen chloride gas inlet 32 is introduced into the chamber along the upper interior chamber walls through hydrochloric gas flow guide 30 while the lower gas curtain comprised of hydrogen or helium or the like is introduced through inlet 34 which is in communication with flow guide 36 which guides the gas curtain along the inner walls of the lower portion of the chamber and is shielded away from the entering slim rod 19 and communication quartz sleeve 21. The various arrangements of process gas entry heads and gas curtain flow guides when utilized in combination provide gas flow patterns which enhance the reaction process as well as effectively deter unwanted chamber wall reactions. The gas curtain inlets 32 and 34 can be arranged in various positions along the chamber walls 23 depending upon the geometry of the chamber itself and the needs for multiple inlets and flow guides. Gas curtains can be parallel to the flow of the reaction gas, for example the hydrogen chloride flow guide 30 which parallels the reaction gas feed head 26 or can be countercurrent to the reaction gas flow as in the case of the hydrogen or helium gas curtain. The preferred embodiment is the utilization of the hydrogen or helium gas curtain in a counterflow pattern to the reaction gas and a parallel gas flow pattern in the opposite end of the chamber of the hydrogen chloride curtain. The reaction gas is set toward the center of chamber 23 while the gas curtains are fed along the inner wall of chamber 23.

The resulting hexagonal silicon body 31 increases in diameter as it proceeds through the CVD chamber 23 reaching a maximum rod diameter 33 at the upper end portion of chamber 23. The continuous process and the apparatus according to the invention provide a gas seal means 37 at the upper end of chamber 23 which permits continuous drawing of the enlarged hexagonal body from the chamber without loss of process gas or contamination of the CVD chamber. The continuous motion of the seed rod and the growth rod is achieved through automatic rod pulling means 39 which are exterior to the CVD chamber 23.

Other embodiments of the invention which are not shown in the Figure would be the utilization of an expansion type bellows chamber affixed to the upper end of the chamber 23 which may or may not be in combination with a gas seal means 37.

In the following examples, the invention is illustrated fully with experimental data where increased deposition rates of silicon from silicon halide-hydrogen process gas is achieved by adding silane in such a way as to avoid dust formation but still permit a significant improvement in the deposition rate. In examples 1 and 2 following, a commercial epitaxial reactor was utilized which allows heating of the silicon substrate wafer to about 1200°C and over and admittance of controlled amounts of silicon halide vapor and silane and hydrogen gas into the reaction chamber. The substrate was placed in a rotating graphite susceptor. The susceptor was heated by an RF coil which was located beneath the susceptor and the gases were injected by means of a nozzle arrangement and impinged upon the substrate surface at a velocity of 15 meters per second. The results as indicated in examples 1 and 2 provide the realization that by adding silane to silicon tetrachloride or trichlorosilane, hydrogen process gas mixtures, an increase in deposition rates occurs. The increase in deposition rates is larger than can be accounted for by silane weight addition alone. The increase in deposition rate was temperature dependent. This relationship has been used to calculate the activation energies of the respective reactions. Adding silane to a silicon halide process reaction gas reduces the activation energy of the silicon delivering reaction. The lower the substrate temperature, the

more significant the improvement becomes. The results of the following examples support the conclusion that silane when added to silicon halide-hydrogen reaction gases in any process changes the silicon-chlorine ratio on the substrate surface significantly more than in the gas phase. The precise surface reaction mechanism is not known but the lowering of the activation energy suggests "catalytic" action and that the effect can be used to improve the economics of any pyrolytic silicon decomposition-deposition process.

Example 1

Fifty milliliters per minute of silane were added to a process gas consisting of 1.3 liters of $SiCl_4$ vapor plus 22.6 liters of hydrogen, increasing the silicon content of the gas by only 3.8% by weight. The deposition rate of silicon was determined to increase from 1.87 microns per minute to 2.47 microns per minute or a 32% enhancement in deposition rate resulting from the silane addition at a substrate surface temperature of 1125°C. When the substrate surface temperatures were brought up to 1150°C, the deposition rate rose from 3.33 microns per minute to 4.1 microns per minute for 23% increase in deposition rate resulting from the silane added to the reaction gas mixture. These rates were measured on (110) silicon planes.

Example 2

Silicon substrates having (112) orientation were utilized in the same reactor conditions as described in Example 1, with the following deposition rate increases measured at 1125°C. The deposition rate utilizing the silicon halide-hydrogen reaction gas feed stream was 1.74 microns per minute whereas the reaction gas feed stream utilizing silane pushed the deposition rate to 2.41 microns per minute resulting in a 39% deposition rate. When repeating the experiment at 1200°C, the rate rose from 4.55 microns per minute to 5.26 microns per minute resulting in a 16% deposition rate increase through the utilization of silane in combination with silicon halide-hydrogen reactor gas systems.

The experimental results as illustrated in Examples 1 and 2 clearly teach that the addition of silane is beneficial for the deposition of elemental silicon from silicon halide-hydrogen reaction gas mixtures because it increases the deposition rate significantly beyond what is expected.

## Claims

1. A method of producing silicon of high purity suitable for semiconductor use, wherein silicon halide-hydrogen reaction gases are fed to a reaction vessel containing a hot silicon carrier body at a temperature of from 1000°C to 1300°C whereby pyrolytic decomposition of the reaction gases occurs and silicon is deposited on to the carrier body, characterised in that the reaction gases contain from 0.2% to 5% by weight of $SiH_4$.

2. A method according to Claim 1 wherein the silicon halide comprises trichlorosilane.

3. A method according to either of Claims 1 and 2 wherein deposition rate reaction conditions are selected such that the increase in deposition rate of silicon relative to the deposition rate achieved in the absence of silane but under otherwise identical conditions is at least three fold greater than the rate increase attributable to the stoichiometric amount of silane in the reaction gases.

4. A method according to any of Claims 1 to 3 wherein silicon is deposited upon hot carrier rod silicon bodies within an at least partially transparent reaction vessel at least partially comprised of glass or quartz, said vessel being in the general shape of a bell jar.

5. A method according to any of Claims 1 to 3 wherein multiple silicon carrier bodies are contacted with the reaction gases in a fluidized bed.

6. A method according to any of Claims 1 to 3 wherein the reaction gases are contacted with multiple silicon carrier bodies within a fluid wall reactor.

7. A method according to any of Claims 1 to 3 wherein the silicon carrier body has the configuration of a ribbon, said ribbon being enclosed in a quartz or glass bell jar-type reactor.

8. A method according to any of Claims 1 to 3 which comprises passing heated silicon slim rods into a chemical vapor deposition chamber through which reaction gas flows; depositing silicon on the slim rods as the rods are moved through the decomposition chamber; and withdrawing the resulting enlarged crystalline silicon bodies from the decomposition chamber.

9. A method according to Claim 8 wherein the slim rods upon entry into the chemical vapor deposition chamber are exposed to concentric, uniform heating through gemetrically focusing heating means comprising a radiant heat furnace surrounding the chamber and focusing the heat onto the slim rods through transparent walls of the chamber.

10. A process according to either of Claims 8 and 9 wherein the continuous movement of the slim rods into and through the chemical vapor deposition chamber is countercurrent to the reaction gas flow.

11. A method according to any of Claims 8 to 10 wherein a virgin slim rod is pulled in situ in a pulling chamber from the action of a seed crystal upon a molten silicon source to give a single crystal silicon slim rod which is passed at decomposition temperatures of gaseous silicon compounds into the chemical vapor deposition chamber; a first gas curtain selected from hydrogen, helium, neon, argon, krypton, xenon, and radon is created along the chemical vapor deposition chamber inner wall, the first gas curtain flowing countercurrent to and entering an

opposite zone to the reaction gas entry and flow; and a hydrogen-chloride curtain is created along the inner wall in the vicinity of reaction gas entry to the decomposition chamber.

**Patentansprüche**

1. Verfahren zur Herstellung von Silicium hoher Reinheit, welches sich zur Halbleiter-Verwendung eignet, worin Siliciumhalogenid-Wasserstoff-Reaktionsgase in ein Reaktionsgefäß eingeführt werden, das einen heißen Siliciumträgerkörper bei einer Temperatur von 1000°C bis 1300°C enthält, wodurch eine pyrolytische Zersetzung der Reaktionsgase eintritt und Silicium auf dem Trägerkörper abgeschieden wird, dadurch gekennzeichnet, daß die Reaktionsgase von 0,2 bis 5 Gew.-% $SiH_4$ enthalten.

2. Verfahren nach Anspruch 1, worin das Siliciumhalogenid Trichlorsilan enthält.

3. Verfahren nach einem der Ansprüche 1 und 2, worin die Abscheidungsgeschwindigkeit-Reaktionsbedingungen so ausgewählt sind, daß die Steigerung der Abscheidungsgeschwindigkeit von Silicium relativ zu der Abscheidungsgeschwindigkeit, die in Abwesenheit von Silan, jedoch ansonsten identischen Bedingungen erzielt wird, mindestens dreimal größer ist als die Geschwindigkeitserhöhung, die auf die stöchiometrische Menge an Silan in den Reaktionsgasen zurückzuführen ist.

4. Verfahren nach einem der Ansprüche 1 bis 3, worin Silicium auf heißen Trägerstab-Siliciumkörpern innerhalb eines zumindest teilweise transparenten Reaktionsfäßes, welches zumindest teilweise aus Glas oder Quartz besteht, abgeschieden wird, wobei das Gefäß im wesentlichen die Gestalt einer Tauchglocke aufweist.

5. Verfahren nach einem der Ansprüche 1 bis 3, worin viele Silicium-Trägerkörper mit den Reaktionsgasen in einem Fließbett in Berührung gebracht werden.

6. Verfahren nach einem der Ansprüche 1 bis 3, worin die Reaktionsgase mit vielen Silicium-Trägerkörpern in einem Fließwand-Reaktor in Berührung gebracht werden.

7. Verfahren nach einem der Ansprüche 1 bis 3, worin der Silicium-Trägerkörper die Konfiguration eines Bandes aufweist, wobei das Band in einen Quartz- oder Glas-Reaktor vom Tauchglockentyp eingeschlossen ist.

8. Verfahren nach einem der Ansprüche 1 bis 3, wobei erhitzte schlanke Siliciumstäbe in eine chemische Dampf-Niederschlagungskammer, durch welche Reaktionsgas strömt, hineingeführt werden, Silicium auf den schlanken Stäben niedergeschlagen wird, wenn die Stäbe durch die Niederschlagungskammer geführt werden, und die sich ergebenden vergrößerten kristallinen Siliciumkörper aus der Niederschlagungskammer abgezogen werden.

9. Verfahren nach Anspruch 8, worin die schlanken Stäbe nach dem Eintritt in die chemische Dampf-Niederschlagungskammer einer konzentrischen einheitlichen Erhitzung durch geometrische Focussierung einer Heizvorrichtung, die einen strahlenförmigen Heizofen umfaßt, der die Kammer umgibt und die Hitze auf die schlanken Stäbe durch die transparenten Wände der Kammer focussiert, ausgesetzt werden.

10. Verfahren nach einem der Ansprüche 8 und 9, worin die kontinuierliche Bewegung der schlanken Stäbe in die chemische Dampf-Niederschlagungskammer und durch diese hindurch entgegengesetzt zu dem Strom des Reaktionsgases verläuft.

11. Verfahren nach einem der Ansprüche 8 bis 10, worin ein neuer schlanker Stab in situ in einer Ziehkammer durch die Wirkung eines Impfkristalls auf eine geschmolzene Siliciumquelle gezogen wird, um einen schlanken Einkristall-Siliciumstab zu ergeben, der bei Zersetzungstemperaturen von gasförmigen Siliciumverbindungen in die chemische Dampf-Niederschlagungskammer geführt wird, ein erster Gasvorhang, ausgewählt unter Wasserstoff, Helium, Neon, Argon, Krypton, Xenon und Radon entlang der Innenwand der chemischen Dampf-Niederschlagungskammer erzeugt wird, wobei der erste Gasvorhang entgegengesetzt zu einer gegenübergelagerten Zone zum Reaktionsgas-Eintritt und -Fluß verläuft und in diese eintritt, und ein Chlorwasserstoff-Vorhang entlang der Innenwand in der Nähe des Reaktionsgas-Eintrittes in die Zersetzungskammer erzeugt wird.

**Revendications**

1. Procédé de production de silicium de haute pureté convenant pour être utilisé dans des semi-conducteurs, où des gaz de réaction constitués d'halogénure de silicium-hydrogène sont introduits dans un récipient de réaction contenant un corps porteur en silicium chaud à une température comprise entre 1000°C et 1300°C, où la décomposition pyrolytique des gaz de réaction se produit et le silicium est déposé sur le corps porteur, caractérisé en ce que les gaz de réaction contiennent entre 0,2% et 5% en poids de $SiH_4$.

2. Procédé selon la revendication 1, où l'halogénure de silicium comprend du trichlorosilane.

3. Procédé selon l'une des revendications 1 et 2, où les conditions de réaction concernant le taux de dépôt sont choisies de façon que l'augmentation du taux de dépôt du silicium par rapport au taux de dépôt obtenu en l'absence de silane mais dans des conditions par ailleurs identiques soit au moins trois fois supérieure à l'augmentation du taux pouvant être attribuée à la quantité stoéchiomètrique de silane dans les gaz de réaction.

4. Procédé selon l'une quelconque des revendications 1 à 3, où le silicium est déposé sur des corps en silicium chauds en forme de tige porteuse à l'intérieur d'un récipient de réaction

au moins partiellement transparent constitué au moins partiellement de verre ou de quartz, ce récipient ayant la forme générale d'une cloche.

5. Procédé selon l'une quelconque des revendications 1 à 3, où de multiples corps porteurs en silicium sont mis en contact avec les gaz de réaction dans un lit fluidisé.

6. Procédé selon l'une quelconque des revendications 1 à 3, où les gaz de réaction sont mis en contact avec de multiple corps porteurs de silicium à l'intérieur d'un réacteur à paroi fluide.

7. Procédé selon l'une quelconque des revendications 1 à 3, où le corps porteur en silicium a la forme d'un ruban, ce ruban étant enfermé dans un réacteur du type cloche en quartz ou en verre.

8. Procédé selon l'une quelconque des revendications 1 à 3, qui comprend le passage de tiges fines en silicium chauffé dans une chambre de dépôt par vapeur chimique dans laquelle circule le gaz de réaction; le dépôt de silicium sur les tiges fines alors qu'elles sont acheminées à travers la chambre de décomposition; et l'extraction hors de la chambre de décomposition des corps en silicium cristallin agrandis résultants.

9. Procédé selon la revendication 8, où les tiges fines lors de leur entrée dans la chambre de dépôt par vapeur chimique sont soumises à un chauffage concentrique, uniforme par des moyens de chauffage géométriquement convergents, comprenant un four de chaleur rayonnante qui entoure la chambre en fait converger la chaleur sur les tiges par l'intermédiaire de parois transparentes de la chambre.

10. Procédé selon la revendication 8 ou la revendication 9 où le mouvement continu des tiges fines pour entrer dans la chambre de dépôt par vapeur chimique et la traverser est â contre-courant du passage des gaz de réaction.

11. Procédé selon l'une quelconque des revendications 8 à 10, où une fine tige vierge est soumise in situ à une traction dans une chambre de traction grâce à l'action d'un cristal d'ensemencement sur une source de silicium à l'état fondu afin de donner une fine tige en silicium monocristallin qui est introduite aux températures de décomposition des composés gazeux de silicium dans la chambre de dépôt par vapeur chimique; un premier rideau de gaz choisis parmi l'hydrogène, l'hélium, le le néon, l'argon, le crypton; le xénon, et le radon est créé le long de la paroi intérieure de la chambre de dépôt par vapeur chimique, le premier rideau de gaz circulant à contre-courant et entrant dans une zone opposée à l'entrée et au courant de gaz de réaction; et un rideau d'acide chlorhydrique est créé le long de la paroi intérieure au voisinage de l'entrée des gaz de réaction dans la chambre de décomposition.

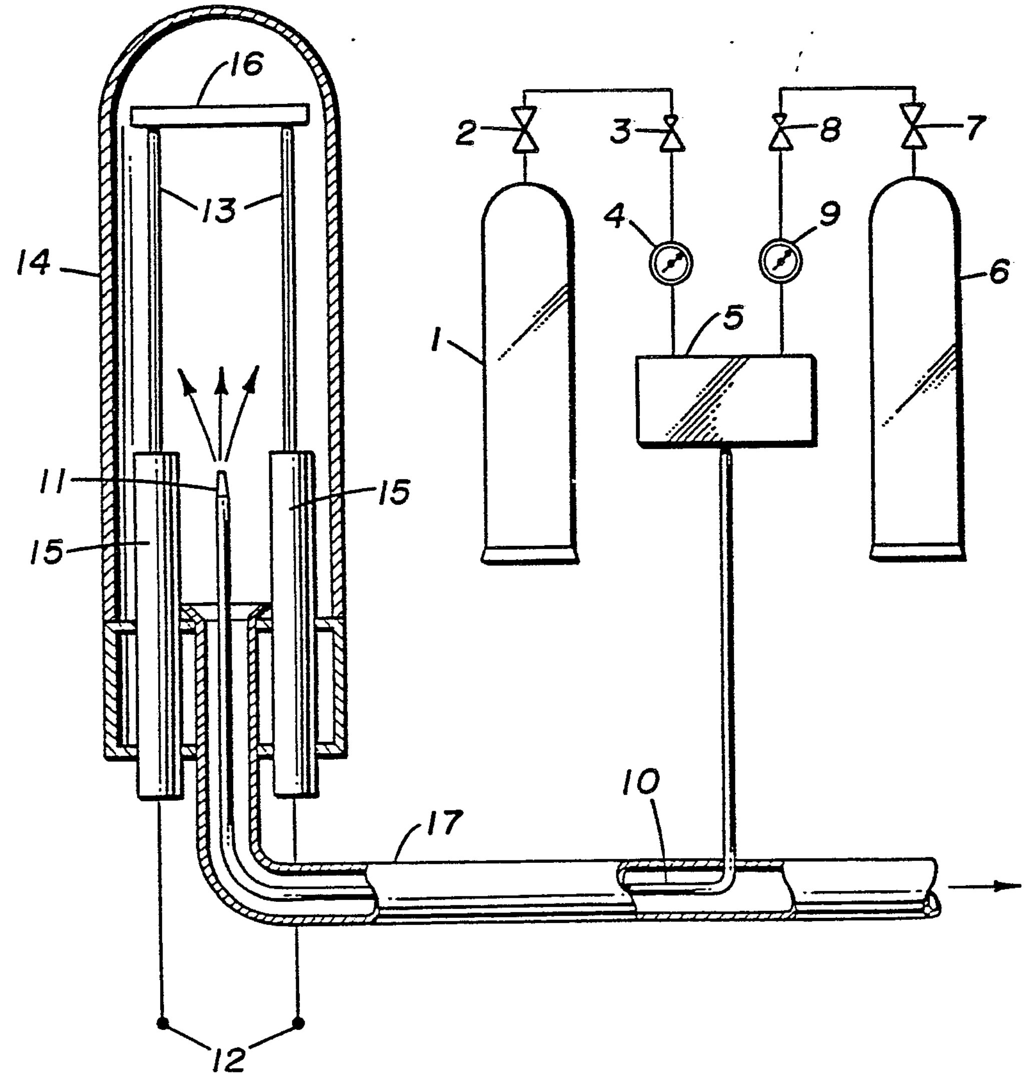


FIG. 1

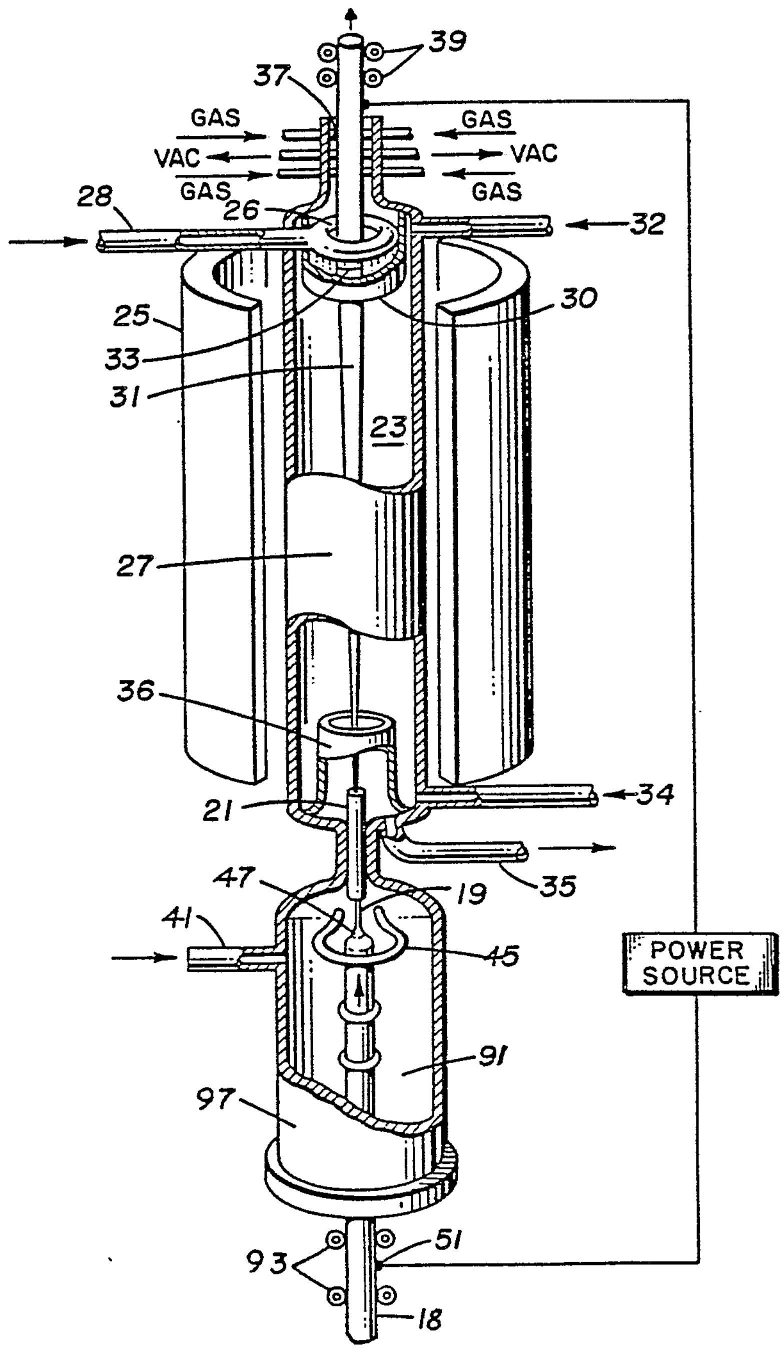
39
37
GAS
GAS
VAC
VAC
GAS
GAS
28
26
32
25
30
33
31
23
27
36
21
34
35
47
19
41
45
POWER SOURCE
91
97
51
93
18

FIG. 2